# EUROPEAN PATENT APPLICATION

(11) **EP 0 545 288 A1**
(43) Date of publication of application: **09.06.1993**
(21) Application number: 92120201.6
(22) Date of filing: 26.11.1992
(51) Int. Cl.: H01L 29/74

(54) **Reverse conducting gate turn off thyristor and method of fabricating same**

(30) Priority: 02.12.1991 JP 317766/91
(71) Applicant: MITSUBISHI DENKI KABUSHIKI KAISHA, Tokyo (JP)
(72) Inventor: Niinobu, Koji, c/o Mitsubishi Denki K. K., Nishi-ku, Fukuoka-shi, Fukuoka (JP); Tokunoh, Futoshi, c/o Mitsubishi Denki K. K., Nishi-ku, Fukuoka-shi, Fukuoka (JP); Morishita, Kazuhiro, c/o Fukuryo Semiconductor, Nishi-ku, Fukuoka-shi, Fukuoka (JP)
(74) Representative: KUHNEN, WACKER & PARTNER

(57) **Abstract**

There is disclosed a reverse conducting gate turn off thyristor which includes a p-type base layer (2) formed on an n-type base layer (1); p-type emitter layers (3), n-type high-concentration layers (4) and an isolating band p-type layer (5) formed below the n-type base layer (1); n-type emitter layers (6) formed on the surface of the p-type base layer (2) above the p-type emitter layers (3); a resistance layer in the form of a groove formed above the isolating band p-type layer (5); an n-type high-concentration layer (11) formed above part of the n-type high-concentration layer (4); an anode electrode (8) short-circuiting the p-type emitter layers (3), n-type high-concentration layers (4) and isolating band p-type layer (5); cathode electrodes (9) formed on the n-type emitter layers (6); a diode portion electrode (10) formed on the p-type base layer (2) above the n-type high-concentration layer (11); and a gate electrode (7) formed above the p-type emitter layers (3). Part of the n-type base layer (1) which lies above the p-type emitter layers (3) sufficiently supports a breakdown voltage in the off state, and part of the n-type base layer (1) which lies above the n-type high-concentration layer (11) is thin enough to reduce residual carriers. Recovery power loss is reduced in a diode portion.

## Description

### BACKGROUND OF THE INVENTION

### Field of the Invention

The present invention relates to reduction in power loss for a reverse conducting gate turn off thyristor (hereinafter referred to as a "reverse conducting GTO").

### Description of the Background Art

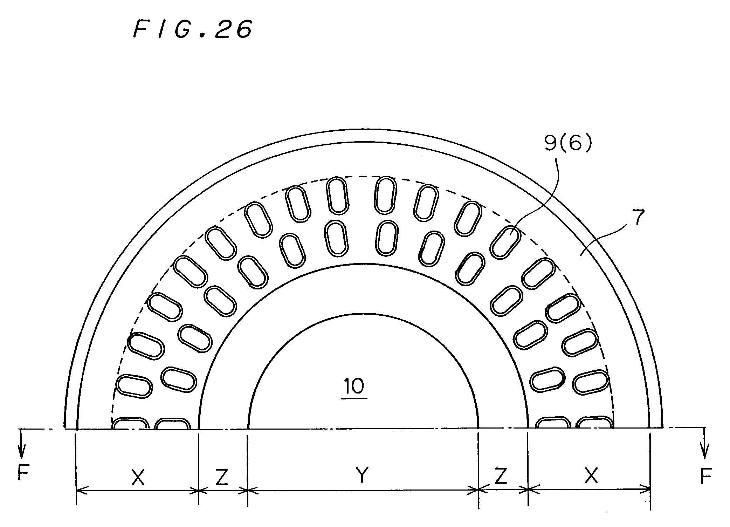

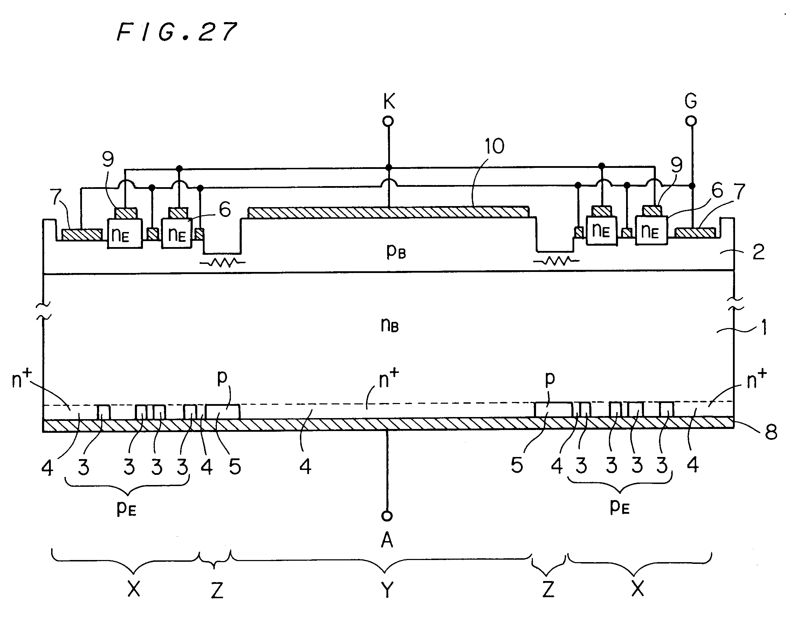

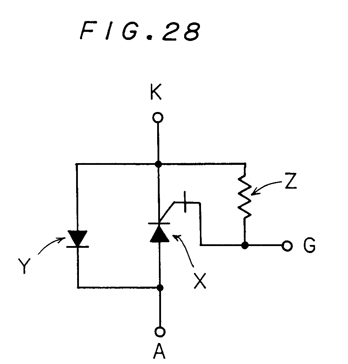

Fig. 26 is a plan view of a half of a conventional reverse conducting GTO, and Fig. 27 is a cross-sectional view taken along the line F-F of Fig. 26. In general, the reverse conducting GTO comprises a GTO portion X, a diode portion Y and an isolating portion Z as shown in Fig. 26. An equivalent circuit of the reverse conducing GTO is shown in Fig. 28 and is disclosed in Japanese Patent Application Laid-Open No. 2-202061, for example.

The internal structure of the respective portions will be described below with reference to Fig. 27. The GTO portion X includes an n-type base layer (n_{B}) 1, a p-type base layer (p_{B}) 2, p-type emitter layers 3 and n-type high-concentration layers 4 formed in the bottom of the n-type base layer 1, and n-type emitter layers 6 formed on the p-type base layer 2. The GTO portion X further includes a gate electrode 7 ohmically contacting the p-type base layer 2, an anode electrode 8 ohmically contacting the p-type emitter layers 3 and n-type high-concentration layers 4, and cathode electrodes 9 ohmically contacting the n-type emitter layers 6. These electrodes 7, 8 and 9 are thin films made of metal such as aluminum.

The diode portion Y includes the n-type base layer 1, the p-type base layer 2 and the n-type high-concentration layer 4. The diode portion Y further includes the anode electrode 8 and a diode portion electrode 10 formed on the p-type base layer 2. The reverse contacting GTO is incorporated into a package such that the diode portion electrode 10 in the diode portion Y and the cathode electrodes 9 in the GTO portion X are pressure contacted by a common metal plate not shown to be at the same potential.

The isolating portion Z includes the n-type base layer 1, the p-type base layer 2 and an isolating band p-type layer 5. The isolating portion Z functions to isolate the resistances indicated by the symbols of resistor in Fig. 27.

The conventional reverse conducting GTO thus constructed is required to includes the n-type base layer 1 having a sufficient thickness for improvement in breakdown voltage in the off state.

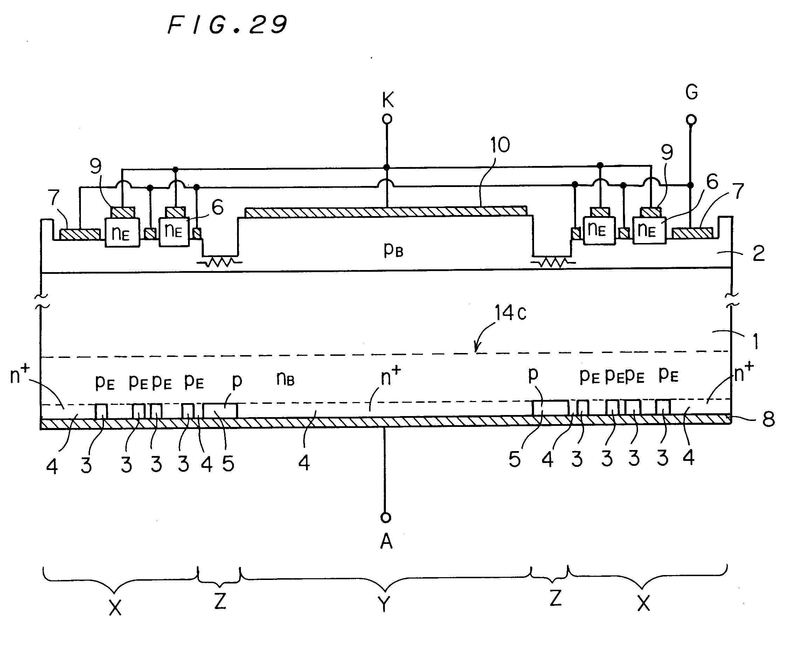

The reason for the requirement will be discussed below with reference to Fig. 29. When the reverse conducting GTO is off, a depletion layer extends from the pn junction formed by the n-type base layer 1 and the p-type base layer 2 toward the n-type base layer 1 to a depletion layer end portion 14c. At this time, holes are introduced from the p-type emitter layers 3 into the n-type base layer 1 in the GTO and isolating portions X and Z. When the n-type base layer 1 is insufficiently thick, the holes easily reach the end portion 14c so that the reverse conducting GTO is liable to be broken down by avalanche breakdown. It is, therefore, necessary that the n-type base layer 1 is sufficiently thick for improvement in the breakdown voltage of the reverse conducting GTO in the off state.

Another problem arises when the thickness of the n-type base layer 1 is increased. That is, increase in thickness of the n-type base layer 1 increases residual carriers in the n-type base layer 1 in the diode portion Y, resulting in increase in power loss (recovery loss) when the polarity of the voltage applied to an anode A and a cathode K is reversed.

### SUMMARY OF THE INVENTION

According to the present invention, a reverse conducting gate turn off thyristor comprises (a) a first semiconductor layer of a first conductivity type having parallel top and bottom major surfaces and provided with a thyristor area, a diode area and a device isolating area located therebetween, the areas being arranged in a direction parallel to the top and bottom major surfaces, the first semiconductor layer including (a-1) a first portion of a relatively high resistance exposed at the top major surface, and (a-2) a second portion of a relatively low resistance selectively exposed at the bottom major surface, the second portion including (a-2-1) a first region provided in the thyristor area, and (a-2-2) a second region provided at least in the diode area in an area including the diode area and the device isolating area, the second region being thicker than the first region, (b) a second semiconductor layer of a second conductivity type formed on the top major surface of the first semiconductor layer and including (b-1) a first portion opposed to the thyristor area, (b-2) a second portion opposed to the diode area, and (b-3) an isolating portion opposed to the device isolating area and having a sheet resistance higher than that of the first and second portions of the first semiconductor layer for electrically isolating the first and second portions of the first semiconductor layer from each other, (c) a third semiconductor layer of the second conductivity type selectively formed in a position corresponding to the thyristor area in the bottom major surface of the first semiconductor layer and exposed complementarily with the first region at the bottom major surface, (d) a fourth semiconductor layer of the second conductivity type formed in a position corresponding to the device isolating area in the bottom major surface of the first semiconductor layer and exposed at the bottom major surface, (e) a fifth semiconductor layer of the first conductivity type selectively formed on the first portion of the second semiconductor layer, (f) a first electrode layer provided on the fifth semiconductor layer, (g) a second electrode layer provided on the second portion of the second semiconductor layer and connected electrically to the first electrode layer, (h) a third electrode layer selectively formed on the first portion of the second semiconductor layer in no contact with the fifth semiconductor layer, and (i) a fourth electrode layer provided on the bottom major surface of the first semiconductor layer in electrical contact with the first, third and fourth semiconductor layers.

The present invention is also intended for a method of fabricating a reverse conducting gate turn off thyristor. According to the present invention, the method comprises the steps of (a) providing a first semiconductor layer of a first conductivity type and of a relatively high resistance having parallel top and bottom major surfaces and provided with a thyristor area, a diode area and a device isolating area located therebetween, the areas being arranged in a direction parallel to the top and bottom major surfaces, (b) forming a second semiconductor layer of a second conductivity type on the top major surface of the first semiconductor layer, (c) selectively introducing an impurity of the first conductivity type into the bottom major surface of the first semiconductor layer to change the first semiconductor layer into a combination of a first portion of a relatively high resistance exposed at the top major surface of the first semiconductor layer, and a second portion of a relatively low resistance selectively exposed at the bottom major surface of the first semiconductor layer and including a first region provided in the thyristor area, and a second region provided in the diode area, the second region being thicker than the first region, (d) selectively introducing an impurity of the second conductivity type into the bottom major surface of the first semiconductor layer to form a third semiconductor layer of the second conductivity type exposed complementarily with the first region at the bottom major surface of the first semiconductor layer in the thyristor area, and a fourth semiconductor layer of the second conductivity type exposed at the bottom major surface of the first semiconductor layer in the device isolating area, (e) selectively introducing an impurity of the first conductivity type into a part of the top surface of the second semiconductor layer which is in corresponding relation to the thyristor area to form a fifth semiconductor layer of the first conductivity type, (f) selectively removing the top surface of the second semiconductor layer to form the second semiconductor layer into a structure having a first protruding portion provided in the thyristor area of the first semiconductor layer, a second protruding portion provided in the diode area, and a recess provided in the device isolating area, the fifth semiconductor layer lying on the first protruding portion, (g) forming a first electrode layer on the fifth semiconductor layer, (h) forming on the second protruding portion a second electrode layer connected electrically to the first electrode layer, (i) forming on the first protruding portion a third electrode layer in no contact with the fifth semiconductor layer, and (j) providing a fourth electrode layer electrically contacting the first, third and fourth semiconductor layers on the bottom major surface of the first semiconductor layer.

According to another aspect of the present invention, the method comprises the steps of (a) providing a first semiconductor layer of a first conductivity type and of a relatively high resistance having parallel top and bottom major surfaces and provided with a thyristor area, a diode area and a device isolating area located therebetween, the areas being arranged in a direction parallel to the top and bottom major surfaces, (b) forming a second semiconductor layer of a second conductivity type on the top major surface of the first semiconductor layer, (c) selectively introducing an impurity of the first conductivity type into the bottom major surface of the first semiconductor layer to change the first semiconductor layer into a combination of a first portion of a relatively high resistance exposed at the top major surface of the first semiconductor layer, and a second portion of a relatively low resistance selectively exposed at the bottom major surface of the first semiconductor layer and including a first region provided in the thyristor area, and a second region provided in the diode area and the device isolating area, the second region being thicker than the first region, (d) selectively introducing an impurity of the second conductivity type into the bottom major surface of the first semiconductor layer to form a third semiconductor layer of the second conductivity type exposed complementarily with the first region at the bottom major surface of the first semiconductor layer in the thyristor area, and a fourth semiconductor layer of the second conductivity type provided in a portion corresponding to the device isolating area in the second region and exposed at the bottom major surface of the first semiconductor layer, (e) selectively introducing an impurity of the first conductivity type into a part of the top surface of the second semiconductor layer which is in corresponding relation to the thyristor area to form a fifth semiconductor layer of the first conductivity type, (f) selectively removing the top surface of the second semiconductor layer to form the second semiconductor layer into a structure having a first protruding portion provided in the thyristor area of the first semiconductor layer, a second protruding portion provided in the diode area, and a recess provided in the device isolating area, the fifth semiconductor layer lying on the first protruding portion, (g) forming a first electrode layer on the fifth semiconductor layer, (h) forming on the second protruding portion a second electrode layer connected electrically to the first electrode layer, (i) forming on the first protruding portion a third electrode layer in no contact with the fifth semiconductor layer, and (j) providing a fourth electrode layer electrically contacting the first, third and fourth semiconductor layers on the bottom major surface of the first semiconductor layer.

In the second portion of the first semiconductor layer, the second region having the low resistance in the diode area is thicker than the first region in the thyristor area. A breakdown voltage in the off state is increased in the thyristor portion, and residual carriers are reduced in the diode portion. This provides for reduction in power loss in the diode portion without impairing the electrical characteristics of the thyristor portion.

In particular, carriers introduced from the third semiconductor layer toward a depletion layer formed by the first and second semiconductor layers pass through the second region of the second portion of the first semiconductor layer and then disappear when the reverse conducting gate turn off thyristor is off. This is useful for improvement in breakdown voltage in the off state.

An object of the present invention is to provide a reverse conducting GTO capable of reducing power loss in a diode portion without impairing electrical characteristics of a thyristor portion. Another object of the invention is to provide a method of suitably fabricating the reverse conducting GTO.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross-sectional view of a reverse conducting gate turn off thyristor of a first preferred embodiment according to the present invention;

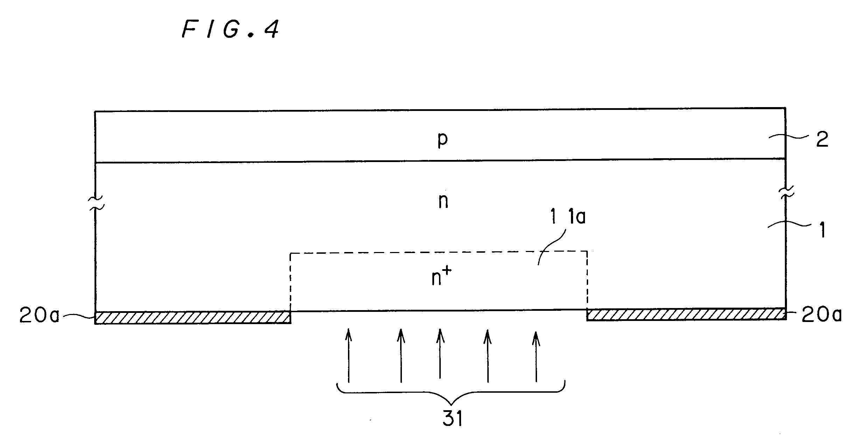

Figs. 2 to 12 are cross-sectional views showing the steps of a method of fabricating the thyristor of Fig. 1;
Fig. 13 is a cross-sectional view showing the configuration of a depletion layer end portion 14a in the thyristor of Fig. 1;
Fig. 14 is a graph showing recovery characteristics of the thyristor of Fig. 1 in comparison with the prior art;
Fig. 15 is a cross-sectional view of a reverse conducting gate turn off thyristor of a second preferred embodiment according to the present invention;
Fig. 16 is a cross-sectional view showing the configuration of a depletion layer end portion 14b in the thyristor of Fig. 15;
Figs. 17 to 25 are cross-sectional views showing the steps of a method of fabricating the thyristor of Fig. 15;
Fig. 26 is a plan view of a half of a conventional reverse conducting gate turn off thyristor;
Fig. 27 is a cross-sectional view of the conventional reverse conducting gate turn off thyristor;
Fig. 28 is a diagram of an equivalent circuit of the reverse conducting gate turn off thyristor; and
Fig. 29 is a cross-sectional view showing the configuration of a depletion layer end portion 14c in the conventional reverse conducting gate turn off thyristor.

### DESCRIPTION OF THE PREFERRED EMBODIMENTS

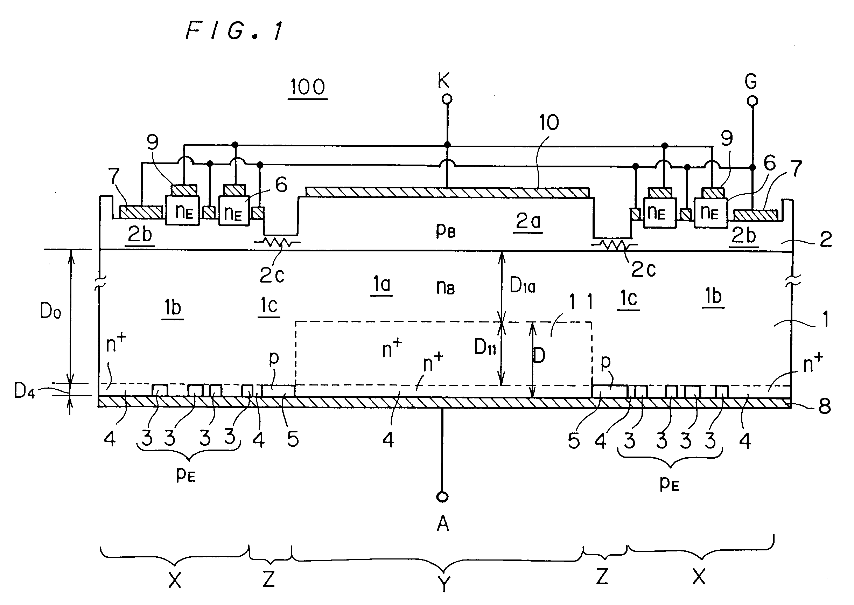

Fig. 1 is a cross-sectional view of a reverse conducting GTO 100 of a first preferred embodiment according to the present invention. The reverse conducting GTO 100 comprises an n-type base layer (n_{B}) 1 and a p-type base layer (p_{B}) 2 formed thereon. The p-type base layer 2 includes a central protruding portion 2a and a peripheral protruding portion 2b. The central and peripheral protruding portions 2a and 2b are isolated from each other by a relatively thin resistance isolating portion 2c formed therebetween. On the peripheral protruding portion 2b are arranged n-type emitter layers (n_{E}) 6.

On the bottom surface of the n-type base layer 1 are arranged p-type emitter layers (n_{E}) 3 opposed to the peripheral protruding portion 2b of the p-type base layer 2. An isolating band p-type layer 5 is formed in an area opposed to the resistance isolating portion 2c. Respective n-type high-concentration layers 4 are formed between the layers 3 and 5 and in an area opposed to the central protruding portion 2a of the p-type base layer 2. An n-type high-concentration layer 11 which is continuous with the n-type high-concentration layer 4 is formed below the central protruding portion 2a of the p-type base layer 2. The n-type high-concentration layer 11 protrudes into the n-type base layer 1. The n-type base layer 1 is conceptually divided into three portions: a central portion 1a lying in the center thereof, a peripheral portion 1b lying in the periphery thereof, and an intermediate portion 1c lying between the portions 1a and 1b.

Preferably, the thicknesses of the respective layers are as follows:
the thickness D₀ of the peripheral and intermediate portions 1b and 1c of the n-type base layer 1 = about 550 µm,
the thickness D₁ₐ of the central portion 1a of the n-type base layer 1 = about 480 µm,
the thickness D₄ of the n-type high-concentration layer 4 = about 30 µm,
the thickness D₁₁ of the n-type high-concentration layer 11 = about 70 µm, and
the total thickness D of the n-type high-concentration layers 4 and 11 = about 100 µm.

The reverse conducting GTO 100 is divided roughly into three portions: a GTO portion X, a diode portion Y and an isolating portion Z.

The GTO portion X includes the n-type emitter layers 6, the peripheral protruding portion 2b of the p-type base layer 2, the peripheral portion 1b of the n-type base layer 1, the p-type emitter layers 3 and the n-type high-concentration layers 4.

The diode portion Y includes the central portion 1a of the n-type base layer 1, the central protruding portion 2a of the p-type base layer 2 and the n-type high-concentration layers 4, 11.

The isolating portion Z includes the intermediate portion 1c of the n-type base layer 1, the resistance isolating portion 2c of the p-type base layer 2 and the isolating band p-type layer 5. The resistance isolating portion 2c is thinner than the central and peripheral protruding portions 2a and 2b, and has a high sheet resistance.

A gate electrode 7 ohmically contacting the peripheral protruding portion 2b of the p-type base layer 2 and cathode electrodes 9 ohmically contacting the n-type emitter layers 6 are formed on the top surface of the reverse conducting GTO 100. A diode portion electrode 10 is formed on the central protruding portion 2a of the p-type base layer 2.

On the bottom surface of the reverse conducting GTO 100 is provided an anode electrode 8 ohmically contacting the p-type emitter layers 3, the n-type high-concentration layers 4 and the isolating band p-type layer 5.

The electrodes 7 to 10 are thin films made of metal such as aluminum.

The plan view of the reverse conducing GTO 100 is identical with that of Fig. 26. It is, however, apparent from the foregoing description that the internal structure of the reverse conducting GTO 100 is different from that of the prior art.

Description will be given hereinafter on the operation of the GTO and isolating portions X and Z of the reverse conducting GTO 100.

The turn-on operation of the reverse conducing GTO 100 will be described below. When a voltage is applied across the electrodes 7 and 9 such that the potentials at the gate and anode electrodes 7 and 8 grow higher than the potential at the cathode electrodes 9, the pn junction formed by the p-type base layer 2 and the n-type emitter layers 6 is biased in the forward direction. Then, holes are introduced from the p-type base layer 2 into the n-type emitter layers 6, and electrons are introduced from the n-type emitter layers 6 into the p-type base layer 2. Since the n-type emitter layers 6, p-type base layer 2 and n-type base layer 1 form an npn transistor, excessive electrons are introduced into the n-type base layer 1 due to the amplification of the npn transistor. Hence the same amount of holes are introduced from the p-type emitter layers 3 into the n-type base layer 1. Since the p-type emitter layers 3, n-type base layer 1 and p-type base layer 2 form a pnp transistor, excessive holes are introduced into the p-type base layer 2.

Once the GTO portion X is turned on, the npn and pnp transistors drive each other, so that a current continues flowing across the anode and cathode electrodes 8 and 9.

Some of the holes introduced from the n-type base layer 1 into the peripheral protruding portion 2b of the p-type base layer 2 are fed back to the diode portion electrode 10 through the resistance isolating portion 2c of the p-type base layer 2. A gate trigger current is required to accordingly increase.

The turn-off operation of the reverse conducting GTO 100 will be described below. When a voltage is applied across the electrodes 7 and 9 such that the potential at the gate electrode 7 is lower than that at the cathode electrodes 9, the pn junction formed by the p-type base layer 2 and the n-type emitter layers 6 is biased in the reverse direction. Holes which tend to flow from the n-type base layer 1 toward the n-type emitter layers 6, when passing through the p-type base layer 2, flow into the gate electrode 7 in order of proximity to the gate electrode 7. The holes that reach the n-type emitter layers 6 are concentrated on the center of the n-type emitter layers 6, until the holes do not reach the n-type emitter layers 6. As a result, the electrons stop flowing from the n-type emitter layers 6 into the p-type base layer 2 so that the reverse conducting GTO 100 is turned off.

Since the diode portion electrode 10 and the cathode electrodes 9 are at the same potential, holes are introduced from the diode portion electrode 10 into the p-type base layer 2. A gate reverse current accordingly increases.

The reverse conducting GTO 100 is turned on/off depending on the level of the voltage applied to the gate G (gate electrode 7) when the voltage is applied across the cathode K (cathode electrodes 9) and the anode A (anode electrode 8) such that the potential at the anode A grows higher than that at the cathode K.

Since the n-type high-concentration layer 11 lies between the n-type high-concentration layer 4 and the n-type base layer 1 in the diode portion Y, the thickness D₁ₐ of the central portion 1a of the n-type base layer 1 in the diode portion Y is thinner than the thickness D₀ of the peripheral portion 1b thereof in the GTO portion X. Therefore, the residual carriers in the central portion 1a of the n-type base layer 1 in the diode portion Y are prevented from increasing, with a sufficient thickness of the peripheral portion 1b of the n-type base layer 1 held in the GTO portion X for improvement in breakdown voltage in the off state.

Specifically, when the voltage is applied such that the potential at the cathode K grows higher than that at the anode A, the diode portion Y is biased in the forward direction, so that a current flows across the anode A and cathode K. Recovery loss is reduced which is generated when the polarity of the voltage applied therebetween is reversed.

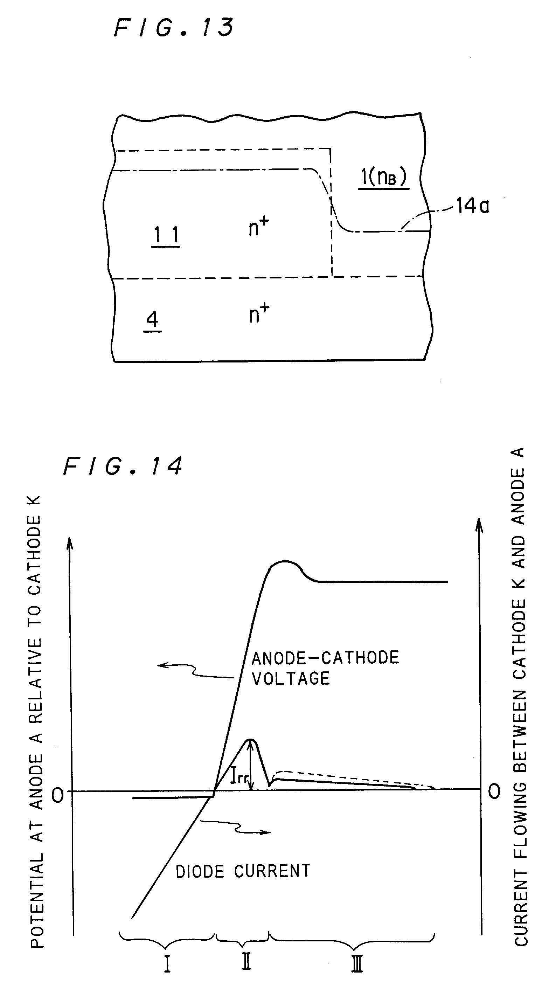

Fig. 13 shows the configuration of an end portion 14a of a depletion layer around the end of the n-type high-concentration layer 11 when the reverse conducting GTO 100 is off. The end portion 14a in the n-type base layer 1 extends more downwardly than that in the n-type high-concentration layer 11 due to a difference in n-type impurity concentration, to hold the breakdown voltage.

Fig. 14 shows recovery characteristics of a current flowing in the diode portion Y. In the graph of a diode current, the solid curve indicates the diode current of the reverse conducting GTO 100 of the first preferred embodiment and the broken curve indicates that of the reverse conducting GTO 100 of the prior art. When the potential at the anode A is lower than that at the cathode K, the diode portion Y enables the diode current to flow between the diode portion electrode 10 and the anode electrode 8 (Region I). As the potential at the anode A becomes higher than that at the cathode K, the diode current reaches a peak corresponding to a recovery current Irr (Region II), and subsequently converges to zero (Region III).

The diode current of the reverse conducing GTO 100 of the first preferred embodiment changes in the same manner as that of the prior art in Regions I and II. In Region III, however, the diode current of the reverse conducting GTO 100 of the first preferred embodiment indicated by the solid curve is decreased as compared with that of the prior art indicated by the broken curve because of a difference in the amount of residual carriers in the n-type base layer 1. Thus the first preferred embodiment affords large reduction in recovery loss which is the integral value of the product of the anode-cathode voltage and the recovery current. It is apparent from the principle of the operation that the presence of the n-type high-concentration layer 11 exerts no influences on the turn on/off operation of the GTO portion X.

Since the GTO portion X and diode portion Y are in general formed on the same base in the reverse conducting GTO, it is preferable that increase in gate trigger current and gate reverse current is minimized. For this reason, the isolating portion Z has a large area to increase the isolation resistance in the reverse conducting GTO 100 of the first preferred embodiment.

Description will be given hereinafter on a method of fabricating the reverse conducting GTO 100.

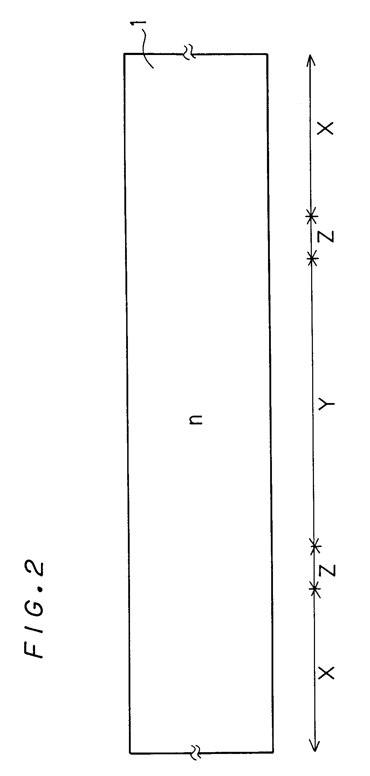

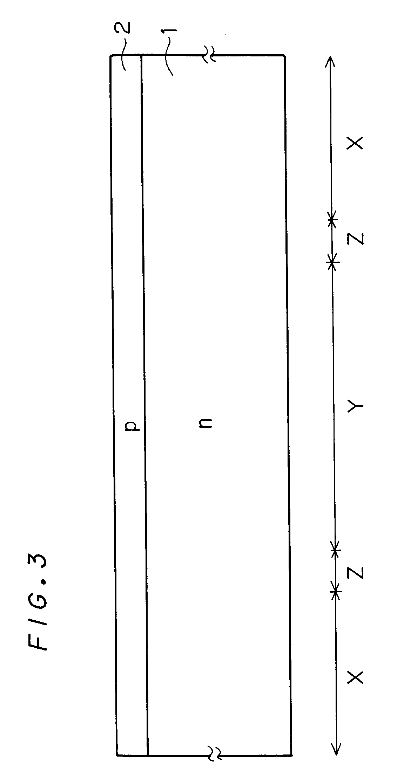

Referring to Fig. 2, the n-type base layer 1 made of n-type silicon is provided. The n-type base layer 1 has parallel top and bottom major surfaces. Areas corresponding to the GTO portion X, diode portion Y and isolating portion Z are previously supposed in the plane parallel to the major surfaces. The p-type base layer 2 is then formed on the top major surface of the n-type base layer 1 as shown in Fig. 3.

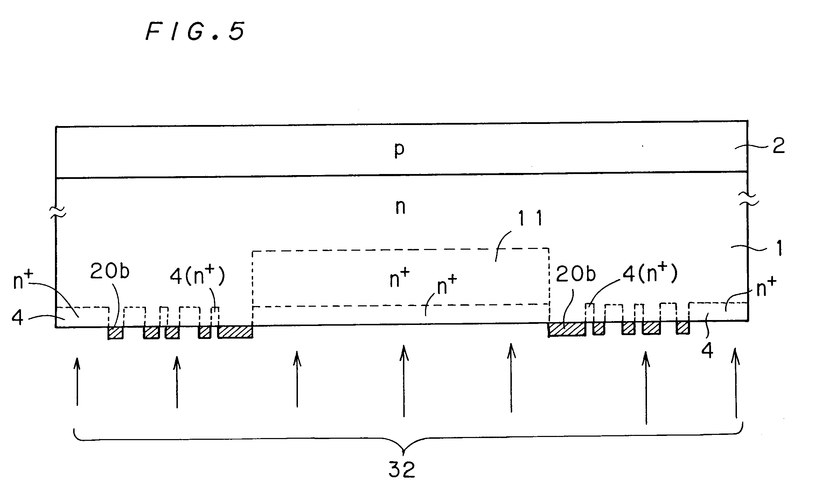

A mask 20a having a window only in the area corresponding to the diode portion Y is formed on the bottom major surface of the n-type base layer 1. An n-type high-concentration layer 11a of about 80 µm thick is selectively formed by phosphorus diffusion 31 using the mask 20a. The mask 20a is removed and a new mask 20b of Fig. 5 is formed. Drive-in diffusion is performed by phosphorus diffusion 32 in an atmosphere of oxygen using the mask 20b. This permits the region of the n-type high-concentration layer 11a to enter deeply into the n-type base layer 1, so that the n-type high-concentration layer 11a extends to the position of about 100 µm deep from the bottom major surface of the n-type base layer 1. The phosphorus diffusion 32 also selectively forms the n-type high-concentration layers 4 of about 30 µm thick in the bottom major surface of the n-type base layer 1. Thus the n-type high-concentration layer 11 is substantially 70 µm thick. It should be noted that the thickness of the n-type base layer 1 to be prepared is selected so as to permit the n-type base layer 1 remaining after the formation of the n-type high-concentration layers 4 to be about 550 µm in thickness.

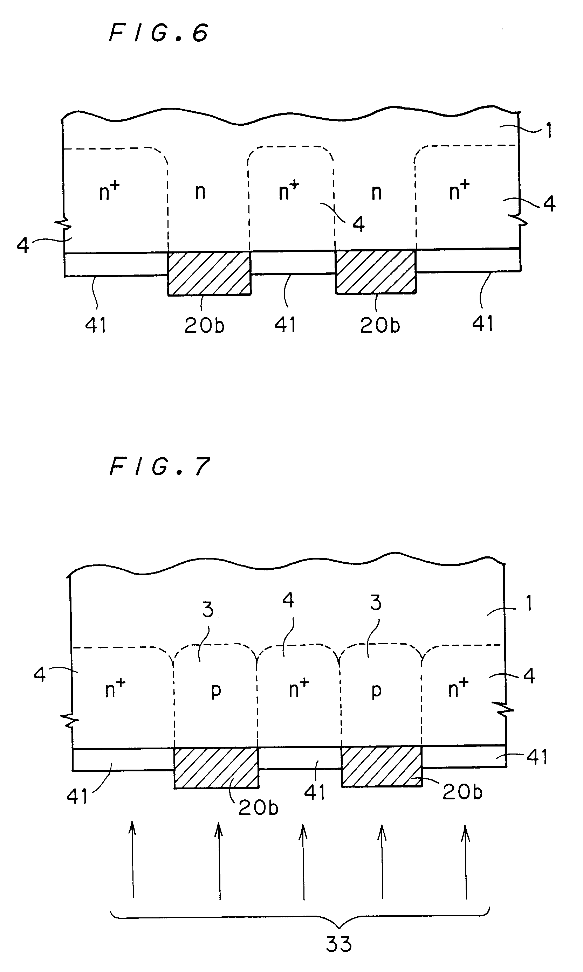

Since the drive-in diffusion of phosphorus is carried out in the atmosphere of oxygen, silicon oxide films 41 (Fig. 6) are formed on the bottom major surface in which the n-type high-concentration layers 4 are formed. Gallium diffusion 33 is performed, with the silicon oxide films 41 and mask 20b remaining unremoved. The n-type high-concentration layers 4 having a high n-type impurity concentration is not turned into p-type, but the p-type emitter layers 3 are formed in parts of the n-type base layer 1 which are covered with the mask 20b (Fig. 7). The isolating band p-type layer 5 shown in Fig. 1 is also formed at this time.

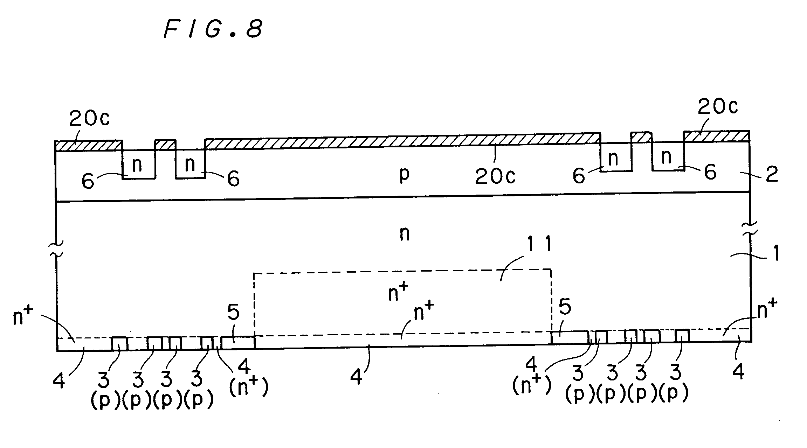

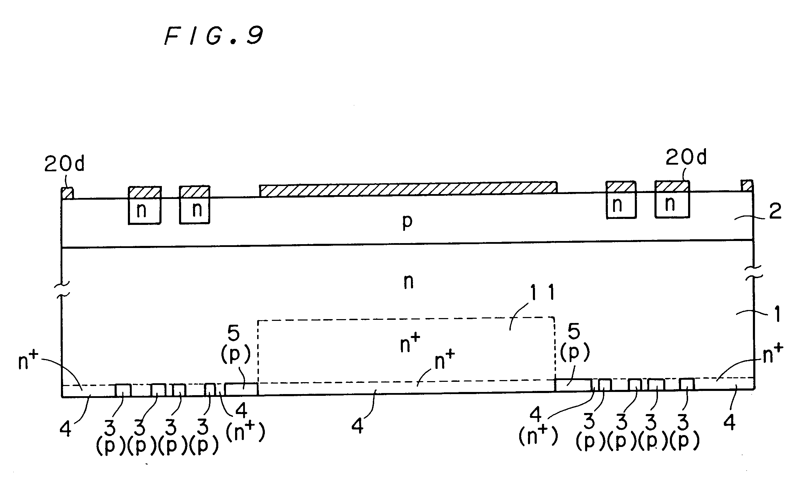

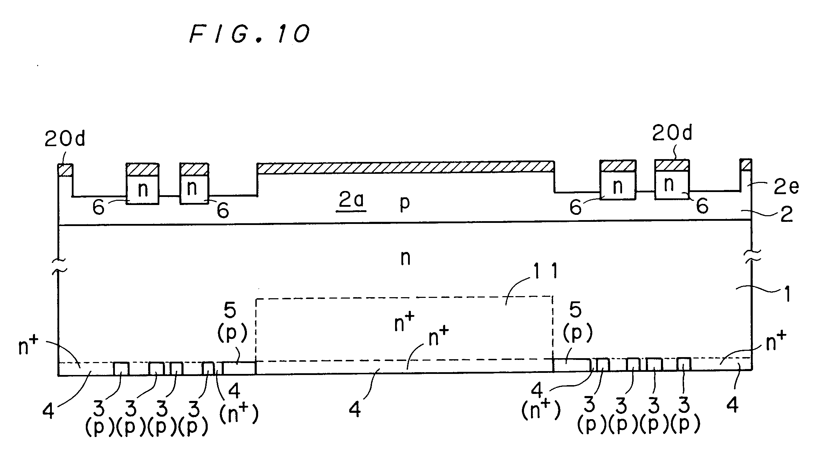

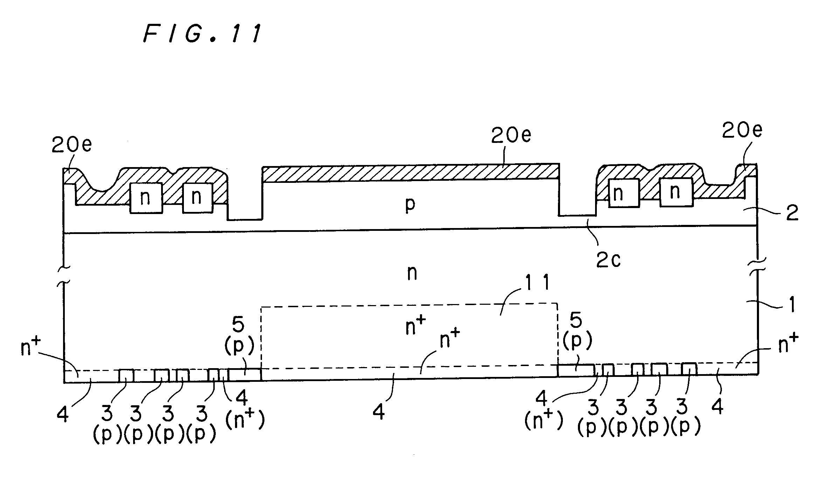

The mask 20b and silicon oxide films 41 are removed, and a mask 20c is selectively formed on the p-type base layer 2 as shown in Fig. 8. The n-type emitter layers 6 are selectively formed by n-type impurity diffusion in the surface of the p-type base layer 2 only in areas above the p-type emitter layers 3. After the removal of the mask 20c, a mask 20d is formed on the p-type base layer 2 (Fig. 9). The p-type base layer 2 is selectively etched about 30 µm down to emboss the central portion 2a and a peripheral edge portion 2e of the p-type base layer 2 and the n-type emitter layers 6 (Fig. 10). The mask 20d is removed, and a mask 20e is formed on the p-type base layer 2 (Fig. 11). The p-type base layer 2 is selectively etched using the mask 20e, whereby the p-type base layer 2 above the isolating band p-type layer 5 is further etched about 30 µm off to provide the resistance isolating portion 2c. The isolating portion Z is thus completed.

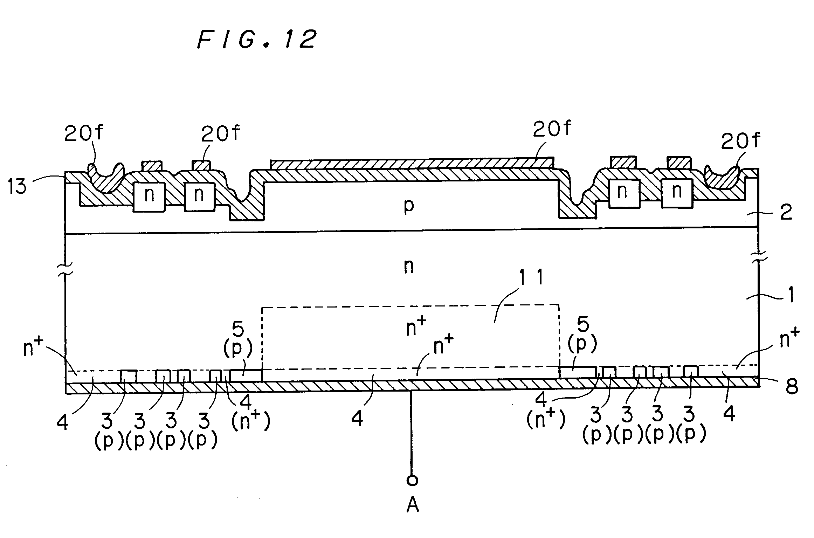

Referring to Fig. 12, the mask 20e is removed. An aluminum electrode 13 is formed over the top surface of the structure thus obtained and a mask 20f is selectively formed on the aluminum electrode 13. The portions uncovered with the mask 20f are selectively etched away, to form the gate electrode 7, cathode electrodes 9 and diode portion electrode 10 of Fig. 1. Then, the anode electrode 8 is formed such that it short-circuits the n-type high-concentration layers 4, p-type emitter layers 3 and isolating band p-type layer 5. The electrodes 7 to 10 are connected to thereby provide the structure of the reverse conducting GTO 100 of Fig. 1.

Since the feature of the present invention is to form the n-type high-concentration layer 11 so as to reduce the thickness of the n-type base layer 1 in the diode portion Y, the n-type high-concentration layer 11 may extend to the isolating portion Z.

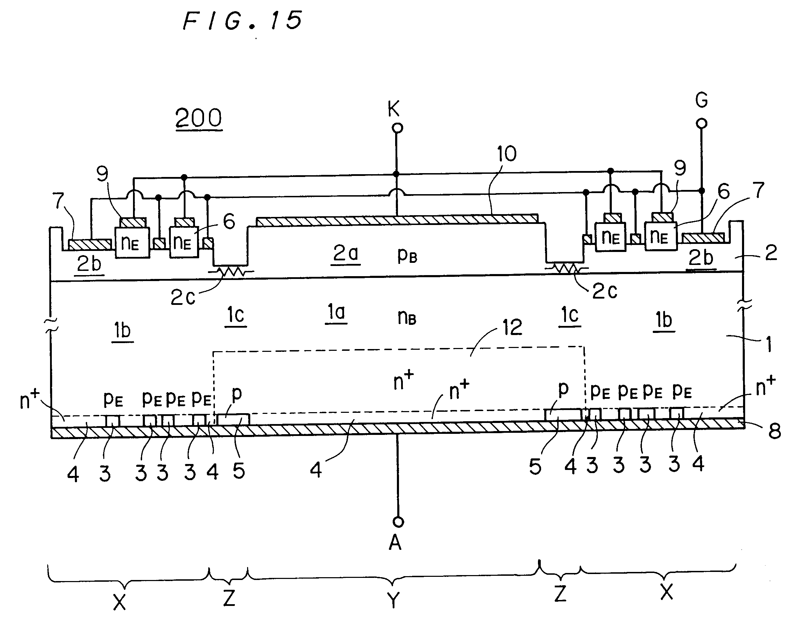

Fig. 15 is a cross-sectional view of a reverse conducting GTO 200 of a second preferred embodiment according to the present invention which is provided from such standpoint. The n-type high-concentration layer 11 in the reverse conducting GTO 100 of the first preferred embodiment is replaced with an n-type high-concentration layer 12 extending widthwise to the isolating band p-type layer 5 in the reverse conducting GTO 200. Other constructions of the reverse conducting GTO 200 are identical with those of the reverse conducting GTO 100 of the first preferred embodiment. Thus the reverse conducting GTO 200 also achieves reduction in residual carriers in the diode portion Y and reduction in recovery loss.

In general, when the voltage applied across the anode and cathode is high in absolute value while the reverse conducting GTO is off, energies such as heat and light generate a diffusion current at the end of the depletion layer extending from the pn junction formed by the n-type base layer 1 and p-type base layer 2. The diffusion current in the GTO portion X passes through the n-type high-concentration layers 4 and then disappears immediately.

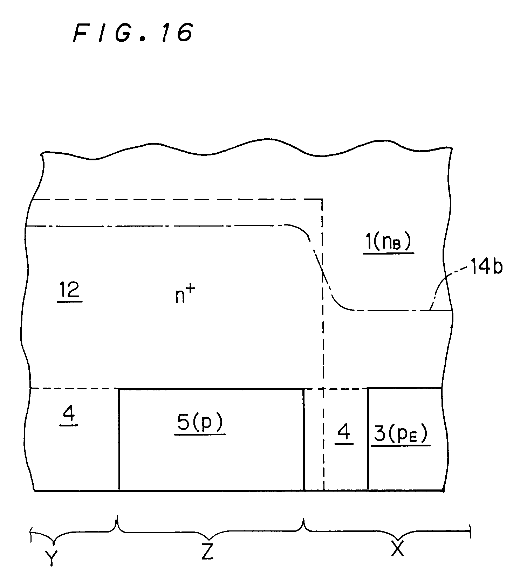

In the isolating portion Z of the conventional reverse conducting GTO of Fig. 27, the holes are introduced from the isolating band p-type layer 5 due to the diffusion current flow, so that the avalanche breakdown is liable to occur. An end portion 14b of the depletion layer around the isolating band p-type layer 5 has a configuration shown in Fig. 16 because of a difference in n-type impurity concentration between the n-type base layer 1 and n-type high-concentration layer 4 in the reverse conducing GTO 200 of the second preferred embodiment. A distance between the end portion 14b and the isolating band p-type layer 5 is longer than a distance between the end portion 14b and the n-type high-concentration layer 4. This enables the n-type high-concentration layer 12 to eliminate the diffusion current around the isolating band p-type layer 5. The reverse conducting GTO 200 of the second preferred embodiment further has an effect to improve the breakdown voltage in the off state.

Description will be given hereinafter on a method of fabricating the reverse conducting GTO 200.

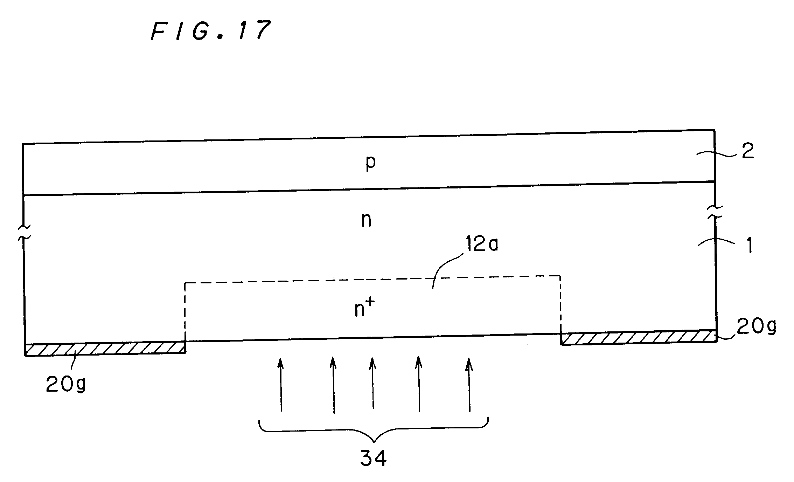

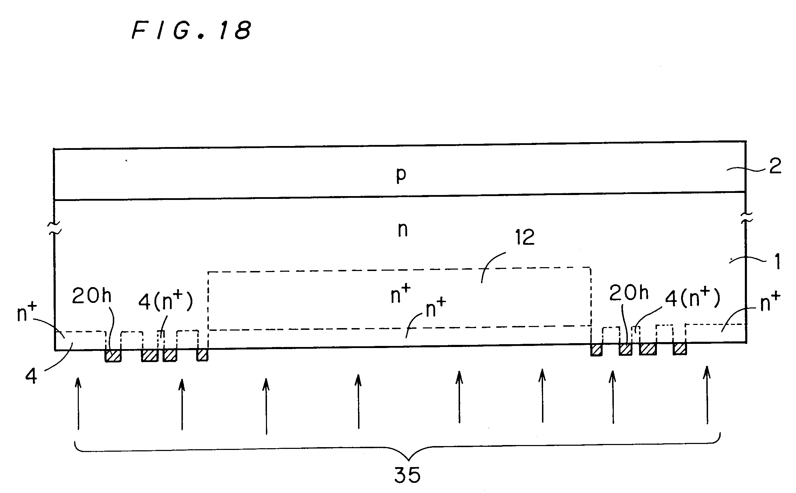

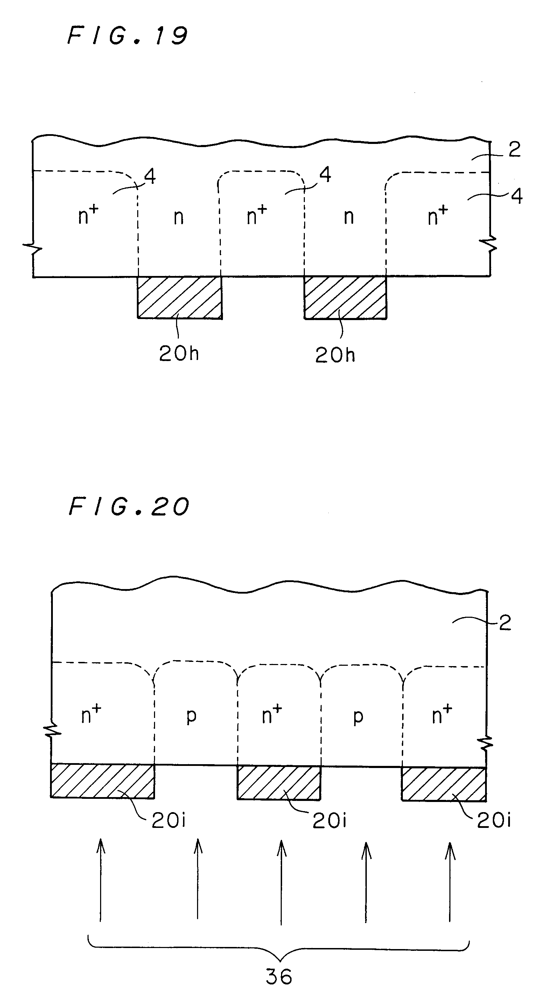

Similarly to the method of fabricating the reverse conducting GTO 100 of the first preferred embodiment, the p-type base layer 2 is formed on the top major surface of the n-type base layer 1 as shown in Fig. 17. After a mask 20g is selectively formed on the bottom major surface of the n-type base layer 1, an n-type high-concentration layer 12a is selectively formed by phosphorus diffusion 34 using the mask 20g. The mask 20g has a window in the area corresponding to the diode portion Y and isolating portion Z of Fig. 3. The mask 20g is removed and a new mask 20h (Fig. 18) is formed. The drive-in diffusion is carried out by phosphorus diffusion 35 using the mask 20h. The region of the n-type high-concentration layer 12a enters deeply into the n-type base layer 1 similarly to the fabrication process for the reverse conducting GTO 100 of the first preferred embodiment, so that the n-type high-concentration layer 12 is formed. The n-type high-concentration layers 4 are selectively formed in the bottom major surface of the n-type base layer 1 by the phosphorus diffusion 35 (Fig. 19). The diffusion is controlled such that the surface concentration of the n-type high-concentration layers 4 is 1 × 10¹⁹ to 5 × 10¹⁹ atoms/cm³. Although gallium diffusion may be subsequently carried out similarly to the fabrication process of the first preferred embodiment to form the p-type emitter layers 3, a process using boron diffusion will be discussed herein.

The surface concentration of diffused boron is generally higher than that of diffused gallium. Supposing that the process of boron diffusion is carried out in the similar manner as that of the gallium diffusion of the first preferred embodiment, the n-type high-concentration layers 4 turn into p-type. To prevent the change in the conductivity type of the n-type high-concentration layers 4, boron diffusion 36 is carried out herein through a selectively formed mask 20i to open only the regions in which the p-type emitter layers 3 and isolating band p-type layer 5 are desired to be formed, as shown in Fig. 20. The mask 20i is selectively formed so as to permit the isolating band p-type layer 5 to be formed below the n-type high-concentration layer 12.

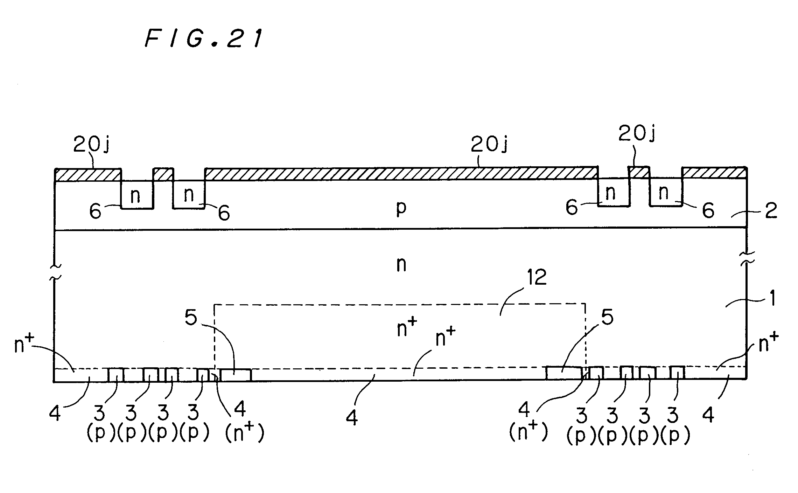

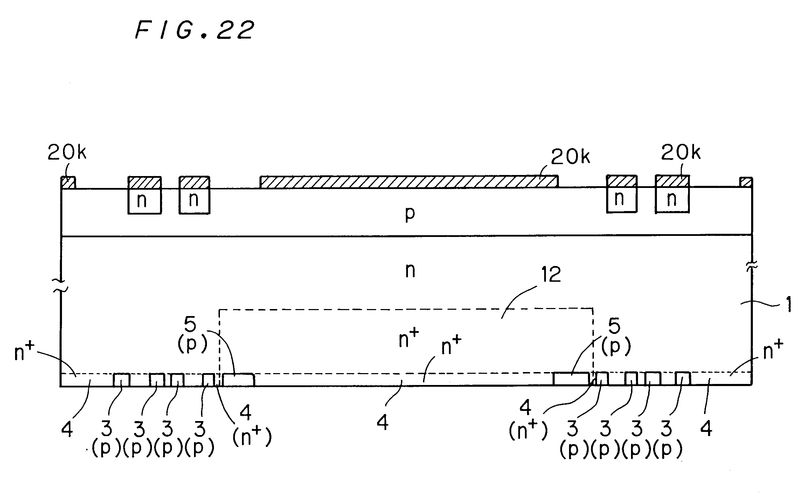

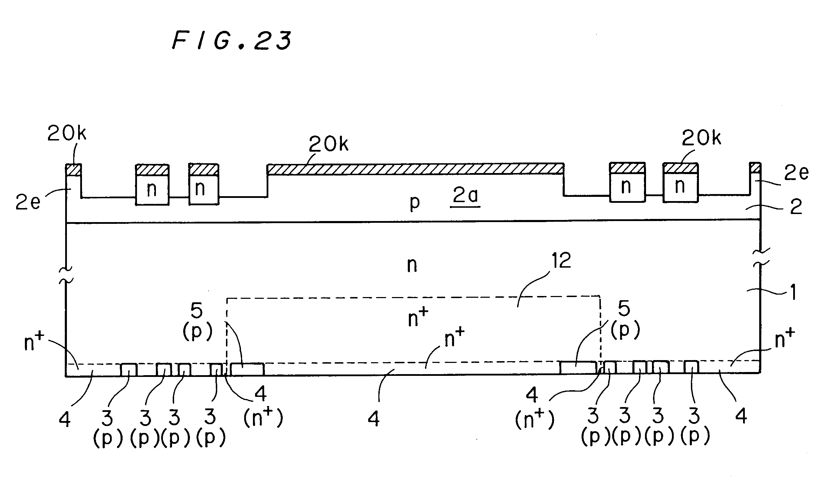

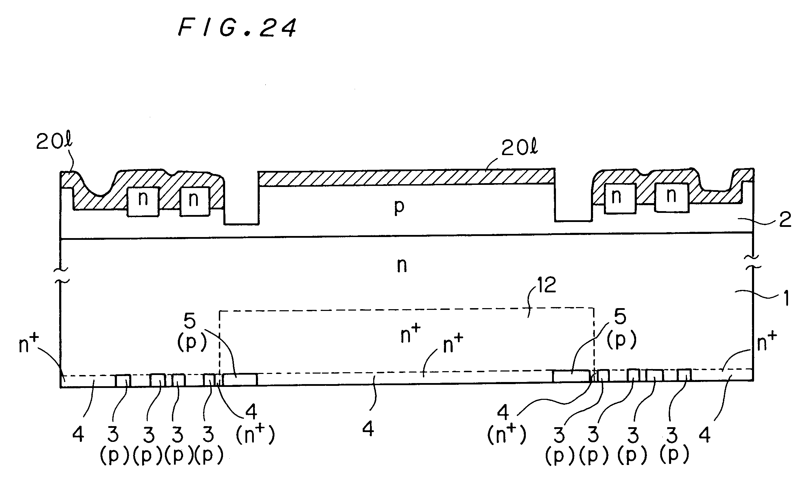

The mask 20i is removed, and a mask 20j is in turn formed selectively as shown in Fig. 21. The n-type emitter layers 6 are selectively formed in the surface of the p-type base layer 2 only in areas above the p-type emitter layers 3, using the mask 20j. The mask 20j is removed and a new mask 20k is formed on the p-type base layer 2 (Fig. 22). The p-type base layer 2 is selectively etched using the mask 20k to emboss the central portion 2a and edge portion 2e of the p-type base layer 2 and the n-type emitter layers 6 (Fig. 23). The mask 20k is removed, and a mask 20ℓ is in turn formed on the p-type base layer 2 (Fig. 24). The p-type base layer 2 is selectively etched using the mask 20ℓ to further etch off the p-type base layer 2 above the isolating band p-type layer 5 (as well as above part of the n-type high-concentration layer 12). The isolating portion Z is thus completed.

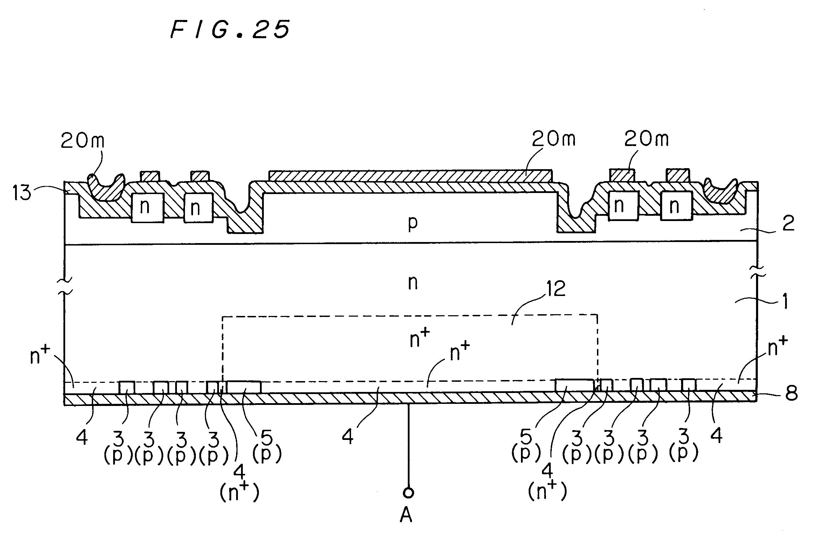

The mask 20ℓ is removed and the aluminum electrode 13 is formed over the top surface of the structure thus obtained. A mask 20m is selectively formed on the aluminum electrode 13 (Fig. 25). The portions uncovered with the mask 20m are selectively etched, to form the gate electrode 7, cathode electrodes 9 and diode portion electrode 10 of Fig. 15. Subsequently, the anode electrode 8 is formed such that it short-circuits the n-type high-concentration layers 4, p-type emitter layers 3 and isolating band p-type layer 5. The electrodes 7 to 10 are connected to each other. The structure of the reverse conducting GTO 200 of Fig. 15 is thus completed.

The thicknesses of the respective layers in the reverse conducting GTO 200 are the same as those of the respective layers in the reverse conducting GTO 100.

While the invention has been shown and described in detail, the foregoing description is in all aspects illustrative and not restrictive. It is therefore understood that numerous modifications and variations can be devised without departing from the scope of the invention.

## Claims

1. A reverse conducting gate turn off thyristor comprising
(a) a first semiconductor layer of a first conductivity type having parallel top and bottom major surfaces and provided with a thyristor area, a diode area and a device isolating area located therebetween, said areas being arranged in a direction parallel to said top and bottom major surfaces, said first semiconductor layer including
(a-1) a first portion of a relatively high resistance exposed at said top major surface, and
(a-2) a second portion of a relatively low resistance selectively exposed at said bottom major surface,
said second portion including
(a-2-1) a first region provided in said thyristor area, and
(a-2-2) a second region provided at least in said diode area in an area including said diode area and said device isolating area, said second region being thicker than said first region,
(b) a second semiconductor layer of a second conductivity type formed on said top major surface of said first semiconductor layer and including
(b-1) a first portion opposed to said thyristor area,
(b-2) a second portion opposed to said diode area, and
(b-3) an isolating portion opposed to said device isolating area and having a sheet resistance higher than that of said first and second portions of said first semiconductor layer for electrically isolating said first and second portions of said first semiconductor layer from each other,
(c) a third semiconductor layer of the second conductivity type selectively formed in a position corresponding to said thyristor area in said bottom major surface of said first semiconductor layer and exposed complementarily with said first region at said bottom major surface,
(d) a fourth semiconductor layer of the second conductivity type formed in a position corresponding to said device isolating area in said bottom major surface of said first semiconductor layer and exposed at said bottom major surface,
(e) a fifth semiconductor layer of the first conductivity type selectively formed on said first portion of said second semiconductor layer,
(f) a first electrode layer provided on said fifth semiconductor layer,
(g) a second electrode layer provided on said second portion of said second semiconductor layer and connected electrically to said first electrode layer,
(h) a third electrode layer selectively formed on said first portion of said second semiconductor layer in no contact with said fifth semiconductor layer, and
(i) a fourth electrode layer provided on said bottom major surface of said first semiconductor layer in electrical contact with said first, third and fourth semiconductor layers.

2. The reverse conducting gate turn off thyristor of claim 1, wherein
said second region is provided only in said diode area, and
the top surface of said fourth semiconductor layer contacts said first portion of said first semiconductor layer.

3. The reverse conducting gate turn off thyristor of claim 2, wherein
said second region having a top surface substantially parallel to said top major surface of said first semiconductor layer.

4. The reverse conducting gate turn off thyristor of claim 3, wherein
said first portion of said first semiconductor layer in said diode area is thicker than said second region.

5. The reverse conducting gate turn off thyristor of claim 4, wherein
said first portion of said fist semiconductor layer in said diode area is about 480 µm thick, and
said second region is about 100 µm thick.

6. The reverse conducting gate turn off thyristor of claim 5, wherein
said first region is about 30 µm thick.

7. The reverse conducting gate turn off thyristor of claim 4, wherein
said isolating portion is thinner than said first portion and said second portion, respectively, of said second semiconductor layer.

8. The reverse conducting gate turn off thyristor of claim 1, wherein
said second region is provided in both said diode area and said device isolating area, and
said fourth semiconductor layer is provided in said second region and is selectively exposed at said bottom major surface.

9. The reverse conducting gate turn off thyristor of claim 8, wherein
said second region has a top surface substantially parallel to said top major surface of said first semiconductor layer.

10. The reverse conducting gate turn off thyristor of claim 9, wherein
said first portion of said first semiconductor layer in said diode area is thicker than said second region.

11. The reverse conducting gate turn off thyristor of claim 10, wherein
said first portion of said first semiconductor layer in said diode area and said device isolating area is about 480 µm thick, and
said second region is about 100 µm thick.

12. The reverse conducting gate turn off thyristor of claim 11, wherein
said first region is about 30 µm thick.

13. The reverse conducting gate turn off thyristor of claim 10, wherein
said isolating portion is thinner than said first portion and said second portion, respectively, of said second semiconductor layer.

14. A method of fabricating a reverse conducting gate turn off thyristor, comprising the steps of
(a) providing a first semiconductor layer of a first conductivity type and of a relatively high resistance having parallel top and bottom major surfaces and provided with a thyristor area, a diode area and a device isolating area located therebetween, said areas being arranged in a direction parallel to said top and bottom major surfaces,
(b) forming a second semiconductor layer of a second conductivity type on said top major surface of said first semiconductor layer,
(c) selectively introducing an impurity of the first conductivity type into said bottom major surface of said first semiconductor layer to change said first semiconductor layer into a combination of
a first portion of a relatively high resistance exposed at said top major surface of said first semiconductor layer, and
a second portion of a relatively low resistance selectively exposed at said bottom major surface of said first semiconductor layer and including
a first region provided in said thyristor area, and
a second region provided in said diode area, said second region being thicker than said first region,
(d) selectively introducing an impurity of the second conductivity type into said bottom major surface of said first semiconductor layer to form
a third semiconductor layer of the second conductivity type exposed complementarily with said first region at said bottom major surface of said first semiconductor layer in said thyristor area, and
a fourth semiconductor layer of the second conductivity type exposed at said bottom major surface of said first semiconductor layer in said device isolating area,
(e) selectively introducing an impurity of the first conductivity type into a part of said top surface of said second semiconductor layer which is in corresponding relation to said thyristor area to form a fifth semiconductor layer of the first conductivity type,
(f) selectively removing said top surface of said second semiconductor layer to form said second semiconductor layer into a structure having
a first protruding portion provided in said thyristor area of said first semiconductor layer,
a second protruding portion provided in said diode area, and
a recess provided in said device isolating area,
said fifth semiconductor layer lying on said first protruding portion,
(g) forming a first electrode layer on said fifth semiconductor layer,
(h) forming on said second protruding portion a second electrode layer connected electrically to said first electrode layer,
(i) forming on said first protruding portion a third electrode layer in no contact with said fifth semiconductor layer, and
(j) providing a fourth electrode layer electrically contacting said first, third and fourth semiconductor layers on said bottom major surface of said first semiconductor layer.

15. The method of claim 14,
wherein said step (c) includes the steps of
(c-1) selectively introducing the impurity of the first conductivity type into said bottom major surface of said first semiconductor layer to form a first semiconductor portion of the first conductivity type in said diode area, and
(c-2) selectively further introducing the impurity of the first conductivity type into said bottom major surface of said first semiconductor layer to increase the thickness of said first semiconductor portion and to selectively form a second semiconductor portion of the first conductivity type in said thyristor area,
said first semiconductor portion being equivalent to said second region,
said second semiconductor portion being equivalent to said first region.

16. The method of claim 15,
wherein said step (c-2) includes the steps of
(c-2-1) forming a mask covering said bottom major surface of said first semiconductor layer in said device isolating area and part of said thyristor area, and
(c-2-2) selectively further introducing the impurity of the first conductivity type into said bottom major surface of said first semiconductor layer using said mask.

17. The method of claim 16,
wherein said step (d) includes the step of
(d-1) selectively introducing the impurity of the second conductivity type into said bottom major surface of said first semiconductor layer using said mask to form said third and fourth semiconductor layers.

18. The method of claim 17,
wherein said step (c-2-2) includes the step of
(c-2-3) selectively further introducing the impurity of the first conductivity type into said bottom major surface of said first semiconductor layer so as to permit said first semiconductor portion to have a top surface substantially parallel to said top major surface of said first semiconductor layer.

19. The method of claim 18,
wherein said step (c-2-3) includes the step of
(c-2-4) selectively further introducing the impurity of the first conductivity type into said bottom major surface of said first semiconductor layer so as to permit said first portion of said first semiconductor layer in said diode area to be thicker than said first semiconductor portion.

20. The method of claim 19, wherein
said impurity of the first conductivity type used in the step (c-2-2) includes phosphorus, and
said impurity of the second conductivity type used in the step (d- 1) includes gallium.

21. A method of fabricating a reverse conducting gate turn off thyristor, comprising the steps of
(a) providing a first semiconductor layer of a first conductivity type and of a relatively high resistance having parallel top and bottom major surfaces and provided with a thyristor area, a diode area and a device isolating area located therebetween, said areas being arranged in a direction parallel to said top and bottom major surfaces,
(b) forming a second semiconductor layer of a second conductivity type on said top major surface of said first semiconductor layer,
(c) selectively introducing an impurity of the first conductivity type into said bottom major surface of said first semiconductor layer to change said first semiconductor layer into a combination of
a first portion of a relatively high resistance exposed at said top major surface of said first semiconductor layer, and
a second portion of a relatively low resistance selectively exposed at said bottom major surface of said first semiconductor layer and including
a first region provided in said thyristor area, and
a second region provided in said diode area and said device isolating area, said second region being thicker than said first region,
(d) selectively introducing an impurity of the second conductivity type into said bottom major surface of said first semiconductor layer to form
a third semiconductor layer of the second conductivity type exposed complementarily with said first region at said bottom major surface of said first semiconductor layer in said thyristor area, and
a fourth semiconductor layer of the second conductivity type provided in a portion corresponding to said device isolating area in said second region and exposed at said bottom major surface of said first semiconductor layer,
(e) selectively introducing an impurity of the first conductivity type into a part of said top surface of said second semiconductor layer which is in corresponding relation to said thyristor area to form a fifth semiconductor layer of the first conductivity type,
(f) selectively removing said top surface of said second semiconductor layer to form said second semiconductor layer into a structure having
a first protruding portion provided in said thyristor area of said first semiconductor layer,
a second protruding portion provided in said diode area, and
a recess provided in said device isolating area,
said fifth semiconductor layer lying on said first protruding portion,
(g) forming a first electrode layer on said fifth semiconductor layer,
(h) forming on said second protruding portion a second electrode layer connected electrically to said first electrode layer,
(i) forming on said first protruding portion a third electrode layer in no contact with said fifth semiconductor layer, and
(j) providing a fourth electrode layer electrically contacting said first, third and fourth semiconductor layers on said bottom major surface of said first semiconductor layer.

22. The method of claim 21,
wherein said step (c) includes the steps of
(c-1) selectively introducing the impurity of the first conductivity type into said bottom major surface of said first semiconductor layer to form a first semiconductor portion of the first conductivity type in said diode area and said device isolating area, and
(c-2) selectively further introducing the impurity of the first conductivity type into said bottom major surface of said first semiconductor layer to increase the thickness of said first semiconductor portion and to selectively form a second semiconductor portion of the first conductivity type in said thyristor area,
said first semiconductor portion being equivalent to said second region,
said second semiconductor portion being equivalent to said first region.

23. The method of claim 22, wherein
said step (c-2) includes the steps of
(c-2-1) forming a first mask covering said bottom major surface of said first semiconductor layer in a first portion of said thyristor area, and
(c-2-2) selectively further introducing the impurity of the first conductivity type into said bottom major surface of said first semiconductor layer using said first mask.

24. The method of claim 23,
wherein said step (d) includes the steps of
(d-1) removing said first mask,
(d-2) forming a second mask covering said bottom major surface of said first semiconductor layer in said diode area and a second portion of said thyristor area, said second portion being complementary with said first portion, and
(d-3) selectively introducing the impurity of the second conductivity type into said bottom major surface of said first semiconductor layer using said second mask to form said third and fourth semiconductor layers.

25. The method of claim 24,
wherein said step (c-2-2) includes the step of
(c-2-3) selectively further introducing the impurity of the first conductivity type into said bottom major surface of said first semiconductor layer so as to permit said first semiconductor portion to have a top surface substantially parallel to said top major surface of said first semiconductor layer.

26. The method of claim 25,
wherein said step (c-2-3) includes the step of
(c-2-4) selectively further introducing the impurity of the first conductivity type into said bottom major surface of said first semiconductor layer so as to permit said first portion of said first semiconductor layer in said diode area to be thicker than said first semiconductor portion.

27. The method of claim 26, wherein
said impurity of the first conductivity type used in the step (c-2-2) includes phosphorus, and
said impurity of the second conductivity type used in the step (d-3) includes boron.
